Europäisches Patentamt

European Patent Office

Office européen des brevets

(11) **EP 1 482 611 A1**

(19)

(12) # DEMANDE DE BREVET EUROPEEN

(43) Date de publication:
**01.12.2004 Bulletin 2004/49**

(51) Int Cl.$^7$: **H01S 5/183**, H01S 3/098

(21) Numéro de dépôt: **04364034.1**

(22) Date de dépôt: **22.04.2004**

(84) Etats contractants désignés:
**AT BE BG CH CY CZ DE DK EE ES FI FR GB GR HU IE IT LI LU MC NL PL PT RO SE SI SK TR**
Etats d'extension désignés:
**AL HR LT LV MK**

(30) Priorité: **26.05.2003 FR 0306361**

(71) Demandeur: **Optogone**
**29280 Plouzané (FR)**

(72) Inventeurs:
• **Verbrugge, Vivien**
**35000 Rennes (FR)**
• **Plouzennec, Loig**
**2566 NE La Haye (NL)**
• **de Bougrenet de la Tocnaye, Jean-Louis**
**29820 Guilers (FR)**

(74) Mandataire: **Vidon, Patrice**
**Cabinet Vidon**
**16 B, rue Jouanet - B.P. 90333**
**35703 Rennes Cedex 7 (FR)**

(54) **Laser à cavité verticale et à émission surfacique, système de télécommunication et procédé correspondant**

(57)     L'invention concerne un laser à cavité verticale et à émission surfacique (VCSEL) comprenant à l'intérieur de ladite cavité au moins un élément optique, possèdant un profil de perte optique variable (44) dans un plan perpendiculaire à un axe de propagation d'au moins un faisceau lumineux traversant ladite cavité de sorte à favoriser un mode transverse dudit laser.

**Fig. 4A**

Printed by Jouve, 75001 PARIS (FR)

EP 1 482 611 A1

**Description**

La présente invention se rapporte au domaine des composants optiques, notamment pour les réseaux optiques à haut débit.

Plus précisément, l'invention concerne les lasers à cavité verticale.

On considère ici des lasers qui se comportent comme des sources laser lorsque l'énergie apportée au laser est supérieure à un seuil d'excitation laser propre au composant et plus particulièrement des lasers à cavité verticale.

Dans ce contexte, les lasers à émission par la surface (VCSEL de l'anglais « Vertical Cavity Surface Emitting Laser ») présentent de nombreux avantages dont, notamment, une grande sélectivité spectrale et une bonne adaptation modale avec les fibres du fait de la nature circulaire et peu divergente du faisceau émis.

Un inconvénient des VCSELs selon l'état de l'art est qu'ils émettent un faisceau qui est multimode transverse, ce qui engendre une diminution de la puissance émise, du couplage de la puissance émise dans les fibres monomodes et de la bande passante du laser ainsi qu'une augmentation du bruit (réduction du TRMS (ou « Taux de Réjection des Modes Spatiaux » de l'anglais SMSR ou « Side Mode Suppression Ratio »).

Ces inconvénients sont notamment décrits dans le document écrit par S. W. Z. Mahmoud, D. Wiedenmann, M. Kicherer, H. Unold, R. Jäger, R. Michalzik, et K. J. Ebeling, intitulé "Spatial investigation of transverse mode tum-on dynamics of VCSELs" (ou en français "Les recherches sur la spatialité des modes transverses changent la dynamique des VCSELs") publié dans la revue IEEE Photon.ics Technology Letters, vol. 13, n° 11, 2001, pp. 1152-1154.

La demande de brevet français déposé le 5 juin 2001 sous le numéro 0107333 par le GET/ENST Bretagne décrit un VCSEL qui possède une large plage d'accordabilité. Ce VCSEL présente néanmoins les mêmes inconvénients.

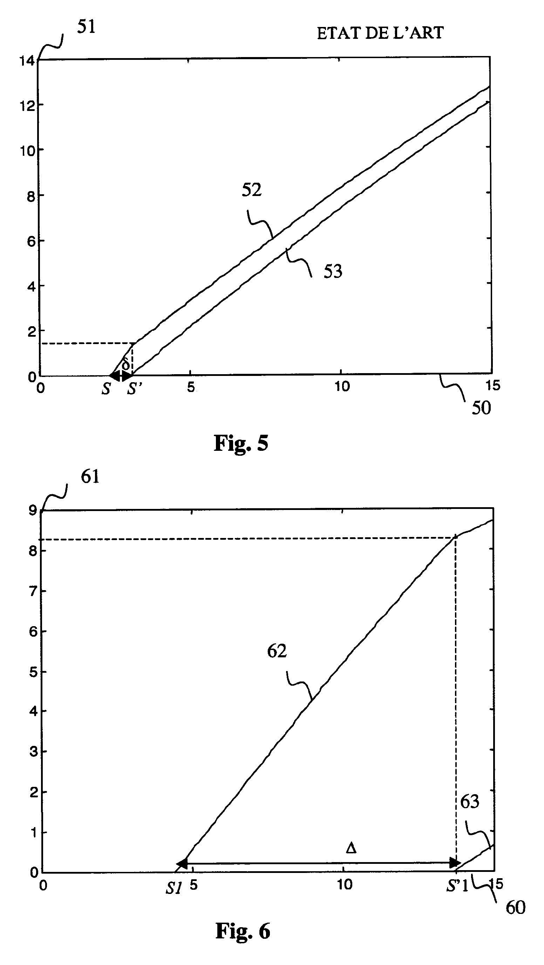

La **figure 5** illustre l'évolution de la puissance optique 51 émise par un VCSEL décrit dans cette demande de brevet FR0107333 en fonction de l'intensité de polarisation 50 (exprimée en mA). Une courbe 52 illustre plus précisément l'évolution de la puissance émise dans le mode transverse fondamental dit LP01 alors que la courbe 53 correspond à la puissance émise dans un deuxième mode appelé premier mode transverse dit LP11. Le seuil $S$ du mode LP01 se situe vers 2,3 mA alors que le seuil $S'$ est voisin de 3 mA. Ainsi, le VCSEL est donc monomode pour une intensité de polarisation située entre 2,3 et 3 mA et multimode lorsqu'elle dépasse 3mA. On constate que l'écart $\delta$ entre les courbes 52 et 53 est de l'ordre de 0,7 mA, ce qui est relativement faible. Aussi, la plage de polarisation et la puissance optique en fonctionnement monomode sont très limitées avec un tel VCSEL.

Différentes techniques sont proposées pour forcer un VCSEL à fonctionner selon le mode fondamental.

Ainsi, dans le document écrit par L. J. Sargent, L. Plouzennec, R. V. Penty, L H. White, et P. J. Leard, intitulé "Gaussian etched single transverse mode Vertical-Cavity Surface-Emitting Laser" et publié lors de la conférence CTuA42, CLEO 2000',pp. 166-167, on effectue une gravure sélective d'une première couche d'un miroir de Bragg supérieur dans le but de réduire la réflectivité modale des couches transverses. Une autre possibilité est décrite dans l'article intitulé « Singlemode output power enhancement of InGaAs VCSELs by reduced spatial hole burning via surface etching» (ou en français «amélioration de la puissance de sortie en mode simple des VCSELs InGaAs en réduisant le gravure de surface») , écrit par H. J. Unold, M. Golling, F. Mederer, R. Michalzik, D. Supper, et K. J. Ebeling et publié dans Electronics Letter, vol. 37, n°9 ,2001, pp. 571-572. Selon cette technique, on grave la surface du VSCEL pour modifier les conditions de guidage des modes transverses. Selon encore une autre technique (décrite dans l'article écrit par K. D. Choquette, A. J. Fischer, K. M. Geib, G. R. Hadley, A. A. Allerman, et J.J. Hindi, intitulé «High single mode operation from hybrid Ion implanted/selectively oxidized VCSELs» (ou « Opération à mode simple de fonctionnement à partir de VCSELs oxydés par des ions hybrides implantés sélectivement » en français) et paru dans le compte-rendu de la conférence IEEE 17th Int. Semiconductor Laser Conf., Monterey, USA, Sept. 2000, pp. 59-60), une oxydation d'une couche d'arsenic de gallium (AsGa) du miroir supérieur provoque un effet lentille favorisant les conditions de guidage du mode fondamental. Ces techniques présentent l'inconvénient d'une mise en oeuvre complexe.

L'invention selon ses différents aspects a notamment pour objectif de pallier ces inconvénients de l'art antérieur.

Plus précisément, un objectif de l'invention est de fournir des lasers VCSEL relativement simples à fabriquer tout en permettant un fonctionnement en monomode dans une large plage de courant de polarisation.

Un autre objectif de l'invention est de mettre en oeuvre des lasers monomodes permettant une puissance d'émission relativement élevée.

Dans ce but, l'invention propose un laser à cavité verticale et à émission surfacique (VCSEL) comprenant à l'intérieur de la cavité au moins un élément optique, remarquable en ce que le ou les éléments optiques possèdent un profil de perte optique variable dans un plan perpendiculaire à un axe de propagation d'au moins un faisceau lumineux traversant la cavité de sorte à favoriser un mode transverse du laser.

Ici, un plan transverse est défini comme étant un plan perpendiculaire à un axe de propagation d'au moins un faisceau lumineux traversant la cavité. Ainsi, le laser possède dans un plan transverse un profil qui favorise le mode transverse fondamental au détriment des autres modes transverses. On peut ainsi augmenter sensiblement l'écart entre les courants seuils d'émission du mode fondamental et des autres modes transverses (ou courants de polarisation nécessaires pour permettre l'émission d'un faisceau lumineux selon respectivement le mode fondamental et les autres modes transverses). En d'autres termes, le laser reste monomode transverse sur une grande plage de courant de polarisation.

Selon une caractéristique particulière, le laser est remarquable en ce que le mode transverse est le mode transverse fondamental.

Le laser fonctionnant en monomode de type transverse fondamental (dans une large plage de polarisation) ainsi obtenu permet de générer un faisceau laser cylindrique et fin particulièrement bien adapté à de nombreuses applications et notamment :

- aux applications de télécommunication pour, par exemple, coupler facilement le laser avec une fibre optique possédant un diamètre fin et/ou obtenir de plus grandes fréquences de modulation ; et
- aux applications de lecture de disque optique.

Selon une caractéristique particulière, le laser est remarquable en ce que let mode transverse est le premier mode transverse.

Ainsi, il est possible d'obtenir un laser fonctionnant avec un unique mode correspondant au premier mode transverse. Ainsi, le laser fonctionnant dans ce mode émet un faisceau dont la section a la forme d'un disque creux, qui est intéressant pour certaines applications (par exemple en médecine, dans le cas où un traitement nécessiterait un éclairement laser dans un zone entourant un point qui lui ne serait pas touché).

Selon une caractéristique particulière, le laser est remarquable en ce qu'on distingue dans le plan au moins deux zones, le profil de perte étant sensiblement constant dans au moins une des zones et différent dans deux zones distinctes.

Ainsi, le profil de perte comprend, par exemple, deux zones (le profil est alors binaire), trois zones ou plus.

D'une manière générale, le profil binaire permet d'élargir la plage de courant de polarisation pour un fonctionnement du laser en monomode et d'augmenter la fréquence de résonance du laser tout en permettant une fabrication relativement simple du laser.

Selon une caractéristique particulière, le laser est remarquable en ce que le rayon d'une zone centrale parmi les zones est compris entre 1 et 5 μm.

Ici, la zone centrale correspond à la zone la plus proche de l'axe du laser. Ainsi, la plage de courant de polarisation permettant un fonctionnement en monomode est relativement large, un optimum étant obtenu pour des valeurs proches de 2 μm.

Selon une caractéristique particulière, le laser est remarquable en ce que le profil de perte varie de manière sensiblement continue dans au moins une partie du plan.

De cette manière, le laser a un profil de perte variant de manière continue :

- dans tout un plan transverse ; ou seulement
- dans une partie, lorsque, par exemple, il présente différentes zônes avec variation brusque du profil de perte lorsque l'on passe d'une zône à l'autre, le profil à l'intérieur de chaque zone étant constant ou variable de manière continue.

Selon une caractéristique particulière, le laser est remarquable en ce que le profil de perte varie de manière sensiblement gaussienne dans au moins une partie du plan.

Un profil gaussien permet également une fabrication relativement aisée du laser tout en permettant de bonnes performances.

Selon une caractéristique particulière, le laser est remarquable en ce que l'écart type de la variation gaussienne du profil de perte dans une zône centrale est compris entre 1 et 5 μm.

La plage de courant de polarisation permettant un fonctionnement en monomode est relativement large lorsque la zone centrale (c'est-à-dire proche de l'axe du laser) est optimisée lorsque l'écart type de la gaussienne est proche de 2 μm.

Selon une caractéristique particulière, le laser est remarquable en ce que la variation du profil de perte dans le plan est à symétrie axiale.

Selon une caractéristique particulière, le laser est remarquable en ce qu'au moins un des éléments optiques comprend des gouttelettes d'une première composition dispersées dans un produit d'une seconde composition, le diamètre des gouttelettes étant variable dans le plan.

Selon une caractéristique particulière, le laser est remarquable en ce qu'au moins un des éléments optiques comprend un matériau de type nano-PDLC.

Ainsi, la fabrication du laser est relativement aisée et permet d'obtenir de bonnes performances (plage de fonctionnement en monomode, puissance d'émission, ...) en fonction du profil de perte obtenu en faisant varier la taille des gouttelettes de cristal dispersées dans un polymère (PDLC pour « Polymer Dispersed Liquid Cristal » ou « Cristal liquide dispersé dans un polymère » en français).

Selon une caractéristique particulière, le laser est remarquable en ce qu'il comprend des moyens d'application d'un champ électrique permettant d'accorder une longueur d'onde associée au laser.

Ainsi, le laser peut fonctionner en mode monomode tout en étant accordable.

Selon une caractéristique particulière, le laser est remarquable en ce qu'il forme un laser de type source laser.

Selon une caractéristique particulière, le laser est remarquable en ce qu'il comprend successivement :

- une première extrémité adaptée à permettre l'émission d'un faisceau laser ;
- un premier miroir ;
- la cavité comprenant le ou les éléments optiques ;
- une première électrode reliée à un premier potentiel électrique ;
- une zône active à multipuits quantique ;
- un second miroir ; et
- une seconde électrode reliée à un second potentiel électrique.

Ainsi, le laser est particulièrement simple à réaliser et relativement compact.

Selon une caractéristique particulière, le laser est remarquable en ce que le second miroir est du type Bragg semi-conducteur.

Ainsi, le laser est encore plus facile à fabriquer.

Selon une caractéristique particulière, le laser est remarquable en ce qu'il comprend une troisième électrode accolée au premier miroir et reliée à au moins un troisième potentiel électrique.

Ainsi, le laser est accordable en fonction du troisième potentiel électrique, tout en restant relativement simple à fabriquer.

L'invention concerne, également un système de télécommunications à haut débit, remarquable en ce qu'il comprend au moins un laser tel qu'illustré précédemment et coopérant avec au moins une fibre optique permettant l'émission d'au moins un faisceau lumineux émis par le laser.

L'invention concerne, en outre, un procédé de fabrication d'un laser à cavité verticale et à émission surfacique (VCSEL), remarquable en ce qu'il comprend :

- une étape de réalisation d'une partie du laser comprenant au moins un élément optique ; et
- une étape d'insolation du élément optique selon un profil d'insolation variable dans un plan perpendiculaire à un axe de propagation d'au moins un faisceau lumineux dans le laser.

Selon une caractéristique particulière, le procédé est remarquable en ce qu'on distingue dans le plan au moins deux zones, le profil d'insolation étant sensiblement constant dans au moins une des zones et différent dans deux des zones distinctes.

Selon une caractéristique particulière, le procédé est remarquable en ce que le profil d'insolation varie de manière sensiblement continue dans au moins une partie du plan.

Selon une caractéristique particulière, le procédé est remarquable en ce que le profil d'insolation varie de manière sensiblement gaussienne dans au moins une partie du plan.

Selon une caractéristique particulière, le procédé est remarquable en ce que la variation du profil d'insolation dans le plan est à symétrie axiale.

Selon une caractéristique particulière, le procédé est remarquable en ce que l'étape d'insolation met en oeuvre :

- au moins une source lumineuse produisant un faisceau d'insolation ; et
- au moins un filtre adapté à faire varier le faisceau d'insolation suivant leprofil d'insolation.

Les avantages du système de communication et du procédé de fabrication étant les mêmes que ceux du laser, ils ne sont pas détaillés plus amplement.

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :

- la figure 1 présente une vue générale en perspective d'un laser, conforme à l'invention selon un mode particulier de réalisation ;
- les figures 2A à 2C illustrent un schéma de principe du laser de la figure 1 ;
- les figures 3A et 3B décrivent plus précisément une partie du laser des figures 1 et 2 ;
- les figures 4A, 4B et 4C présentent un procédé de fabrication du laser des figures précédentes ;
- la figure 5 illustre la puissance optique émise en fonction de l'intensité de polarisation pour un laser connu en soi ;
- les figures 6 et 7 présentent la puissance optique émise en fonction de l'intensité de polarisation pour un laser illustré en figure 1 et 2 ;
- les figures 8 et 9 illustrent des courants de seuil en fonction de l'intensité de polarisation pour un laser illustré en regard des figures 1 et 2A ;
- la figure 10 donne un exemple d'évolution de la fréquence d'émission en fonction du rayon de profil d'un laser selon les figures 1 et 2A ; et
- la figure 11 présente une puissance d'émission optique en fonction d'une intensité de polarisation pour des lasers accordables selon l'invention.

## 1. Principe général de l'invention

Le principe général de l'invention repose sur un laser VCSEL comprenant un profil de perte transverse variable (avec ou sans discontinuité des coefficients de perte), les variations du profil de perte étant déterminée de sorte que l'écart entre les intensités de polarisation au seuil permettant respectivement des émissions selon le mode transverse fondamental et le premier mode transverse soit grand. Ainsi, la plage d'intensité de polarisation située entre les deux seuils pour forcer le VCSEL à fonctionner de façon monomode transverse est relativement large. Ce profil permet donc de favoriser soit mode transverse fondamental soit un autre mode d'une manière souple et simple à réaliser.
Par ailleurs, la couche située dans la cavité du VCSEL peut être une zone à phase variable permettant d'accorder la longueur d'onde d'émission du laser.
L'invention concerne également le procédé de fabrication correspondant d'un laser VCSEL, ce procédé comprenant une insolation avec variation spatiale d'une couche située dans la cavité du laser, cette variation étant configurée de sorte à favoriser l'un des modes transverse.

## 2. Réalisation d'un laser selon l'invention.

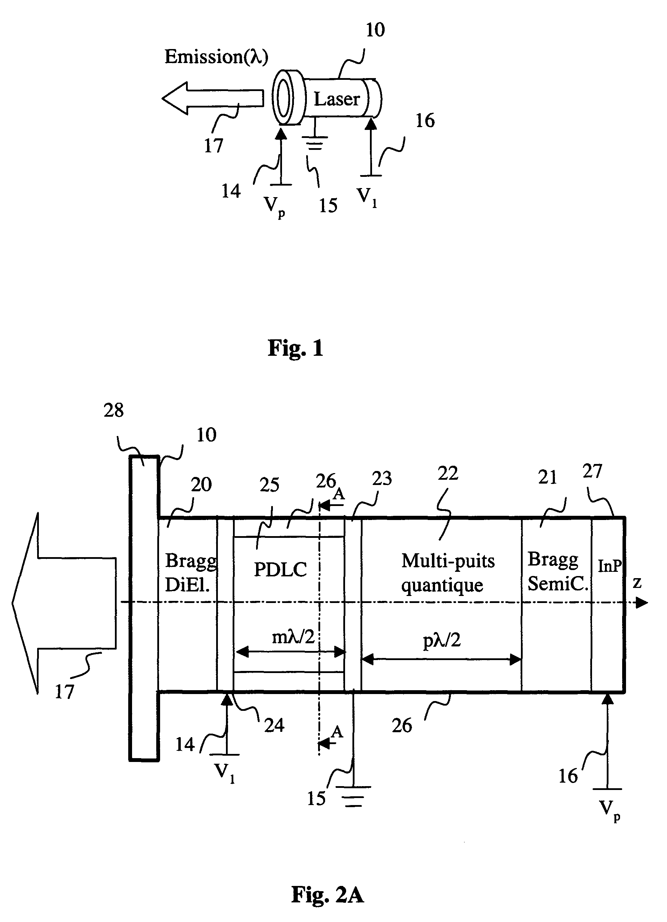

On présente schématiquement (les échelles n'étant pas respectées), en relation avec la figure 1, un mode préféré de réalisation d'un laser VCSEL accordable 10.
On note que le laser 10 est soumis à différents potentiels électriques :

- un point 16 est relié à un potentiel $Vp$ de pompage électrique du laser 10;
- un point 14 est soumis à un potentiel $V_1$ qui permet d'accorder la longueur d'onde du laser 10 en fonction de la valeur de $V_1$; et
- et un point 15 est soumis à un potentiel nul.

Le laser 10 est adapté à émettre un faisceau optique 17 de longueur d'onde λ suivant un axe $z$ de propagation, le laser 10 étant préférentiellement sensiblement à symétrie axiale autour de cet axe. Ce faisceau peut être émis en espace libre ou dirigé vers une ou plusieurs fibres optiques associées au laser 10.
Selon une variante non représentée le pompage du laser est optique. Le laser n'est alors pas relié au potentiel Vp mais est alimenté par un faisceau optique.
Selon une autre variante de l'invention permettant notamment de réaliser une matrice de lasers pour former un composant émettant dans des longueurs d'ondes distinctes ou plusieurs composants séparés, le point 14 est soumis à plusieurs potentiels $V1, V2, ... Vn$, chacun de ces potentiels étant relié à une électrode d'ITO gravée sur un substrat (par exemple en verre transparent) perpendiculaire à l'axe du laser 10 et correspondant à une longueur d'onde d'émission particulière. Si un composant comprenant plusieurs électrodes émet dans plusieurs longueurs d'ondes distinctes, les faisceaux en sortie peuvent alors, notamment, être transmis vers différentes fibres optiques. L'ensemble des électrodes sur le substat peut notamment former un pavage du substrat de sorte à optimiser le nombre d'électrodes en fonction de la surface du substrat ; ainsi, selon l'invention, on peut réaliser un substrat sur lesquel sont imprimés neuf électrodes réparties régulièrement dans une matrice de trois rangées comprenant chacune trois électrodes.
La **figure 2A** illustre schématiquement de principe du laser tel qu'illustré en regard de la figure 1, sous la forme d'une coupe longitudinale.
Le laser comprend une cavité fermée par deux miroirs de type DBR :

- un diélectrique semiconducteur 21 à 45 paires dont les éléments sont respectivement d'indices à 3,41 et 3,16 à une longueur d'onde égale à 1,45 µm, en respectivement quaternaire 1,45 µm (noté Q1,45) et TnP, le diélectrique étant accolé à un substrat transparent 27 d'InP (un Bragg semiconducteur étant plus simple à réaliser qu'un Bragg diélectrique, la zone acture active, le Bragg lui-même et le substrat pouvant être fabriqués en une seule étape correspondant à des dépôts successifs et répétés d'une couche d'InP et de quaternaire 1,45 µm); et

- un miroir Bragg diélectrique 20 de type DBR en $SiO_2$ et $TiO_2$ à 8,5 paires d'indice respectifs 1,46 et 2,23 à 1,55 µm et accolé à un substrat transparent 28.

Les miroirs 20 et 21 sont perpendiculaires à l'axe longitudinal z d'émission du faisceau lumineux (en d'autres termes, ils sont dans un plan transverse).

Le pompage électrique du laser 10 se fait par le substrat 27 auquel est relié le potentiel Vp. Le substrat 28 permet la collecte de l'émission laser par le biais d'optiques appropriées (par exemple, des micro-lentilles de couplage).

Ainsi, les miroirs Bragg 20 et 21 sont calculés pour être :

- très réflectifs à 1,55 µm (99,8% de réflexibilité pour le Bragg 20 et 99,7% pour le miroir 21) ; et
- transparents à 980 nm (la réflectivité est inférieure à 15%).

La cavité comprend, quant à elle, des éléments successifs suivants :

- une zone active 22 à trois multi-puits quantiques de sept puits en InGaAs (Indium Gallium Arsenic) dans des barrières (quaternaire de 1,18 µm noté Q1,18), la zone 22 étant accolée au Bragg 21 et les puits étant placés sur les maxima de champ stationaire intra-cavité lorsque le laser émet à 1,15 µm (on réalise ainsi un gain périodique).
- une première électrode 23 reliée au potentiel électrique nul 15 ;
- une zone 25 de phase variable contenant un cristal liquide de type nano-PDLC, la zone 25 étant fermée sur les cotés par une couche 26 de polyimide ; et
- une électrode 24 de type ITO perpendiculaire à l'axe z relié au potentiel $V_1$ accolée au miroir 21.

La zone active 22 possède un indice d'environ 3,3 et une longueur de l'ordre de 700 nm. La zone 25 de phase variable a un indice voisin de 1,55 et une longueur d'environ 6 µm, correspondant à une épaisseur optique égale à 6λ.

Les électrodes 14 et 15 sont prises suffisamment peu épaisses (quelques dizaines de nanomètres) pour être considérées comme transparentes.

L'application d'un champ électrique variable $E$ créé par la différence de potentiel entre les électrodes 23 et 24 et appliqué parallèlement à la direction de propagation d'émission (selon l'axe z du laser 10) à la zone 25 de phase variable permet d'accorder la longueur d'onde de résonance de la cavité. On peut ainsi obtenir une variation de la longueur d'onde du laser de 20 nm autour de 1,55 µm pour un potentiel $V_1$, égal à 100 Volts.

La faiblesse de la réflexion à l'interface semi-conducteur/nano-PDLC permet de s'affranchir du recours au traitement anti-reflet qui compliquerait la structure et réduirait le facteur de recouvrement longitudinal pour une même longueur de cavité et de zone de déphasage.

Pour certains modes de réalisation, on peut cependant prévoir d'avoir recours à un traitement anti-reflet.

Le choix des épaisseurs relatives des deux éléments constituant la cavité constitue un compromis entre :

- une valeur raisonnable d'épaisseur active (c'est-à-dire suffisamment grande) pour obtenir un facteur de recouvrement raisonnable donc un seuil laser classique ; et
- une zone déphasante la plus grande possible pour obtenir une plage d'accordabilité la plus grande possible.

L'épaisseur totale quant à elle est choisie suffisamment faible pour obtenir un ISL compatible avec une accordabilité (c'est-à-dire ISL supérieur à la bande d'accordabilité) sans saut de mode et avec des tensions de polarisation du nano-PDLC envisageables. L'ISL est inversement proportionnel à la longueur de la cavité. C'est donc la faible longueur de la cavité qui fait que l'ISL est suffisamment grand. Les paramètres caractérisant le laser 10 sont les suivants :

- indice du verre (substrat) :  1,5 ;
- indice du quaternaire Q 1,18 :  3,33 ;
- Indice de l'InGaAs (puits quantique) :  3,56 ;
- Indice *no* du nano-PDLC :  1,513 ; et
- Champ d'accordabilité $V_1$ appliqué :  30V/µm.

Un cristal liquide formé en gouttelettes dispersées dans un milieu polymère, par exemple de type PDLC, dont la taille varie selon la puissance d'insolation effectuée lors de la fabrication du laser peut avoir différents comportements physiques selon la dimension des gouttelettes par rapport à la longueur d'onde d'utilisation (1,55 µm) :

- pour des gouttelettes de diamètre compris entre 10 et 100 nm, le matériau se comporte comme un déphaseur variable ; alors que
- pour des gouttelettes de diamètre compris entre 500 et 1000 nm, le matériau se comporte comme un diffuseur aléatoire et atténue la lumière.

La transition entre ces deux phases s'effectue de manière continue et on observe des comportements intermédiaires où à la fois déphasage et atténuation sont présents. Selon l'invention, on exploite cette propriété en insolant le matériau compris dans la zone 25 différemment lors de la fabrication du laser 10.

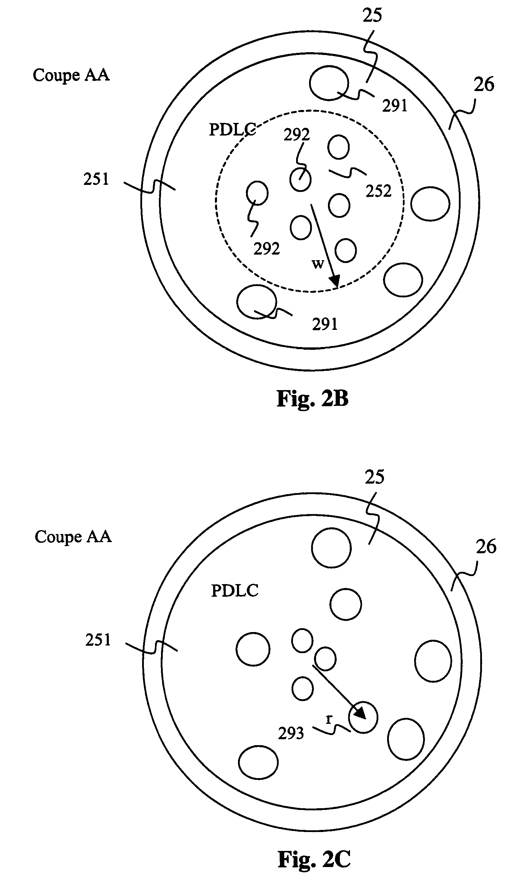

Ainsi, le diamètre des gouttelettes de nano-PDLC compris dans la cavité 25 varie dans un plan perpendiculaire à l'axe z du laser 10 (plan transverse). La **figure 2B** est une coupe AA de la zone 25 du laser 10 tel qu'illustré en regard de la figure 2A et présente schématiquement le diamètre des gouttelettes de nano-PDLC (les échelles relatives n'étant pas respectées).

Ainsi, selon un mode de réalisation du laser 10 dit à profil de pertes binaire, la zone 25 est divisée en deux zones distinctes 251 et 252 concentriques de diamètres respectifs 100 µm et 4 µm, le profil binaire présentant une discontinuité dans la taille de gouttelettes entre les deux zones. La première zone 251 centrale de rayon $w$ valant 2 µm comprend des gouttelettes 292 de diamètre proche de 100 nm plus faible que le diamètre des gouttelettes 291 comprises dans la seconde zone 252 qui est voisin de 500 nm (la seconde zone 252 étant elle-même d'un diamètre proche de 100 µm très supérieur à celui de la première zone 251). Un coefficient de perte $\alpha$ étant, par définition, le coefficient de perte de puissance optique dans un matériau. Si $P_0$ et $P_1$ sont les puissances respectivement incidente et transmise par le matériau et $l$ la longueur du matériau, $P_0$ et $P_1$ suivent la relation $P_1 = P_0 e^{-\alpha l}$. Selon le mode de réalisation décrit ici, le coefficient de perte $\alpha_{npdlc}$ est égal à 13 cm$^{-1}$ dans la zone 251 et vaut 50 cm$^{-1}$ dans la zone 252.

Selon une variante de ce mode de réalisation, le laser présente un profil discontinu à plusieurs zones : la zone 25 est divisée en au moins deux zones (par exemple deux, trois, quatre ou plus) de forme quelconque non nécessairement cylindrique (par exemple parallélipédique) ou concentrique, chacune des zones contenant des gouttelettes de taille sensiblement égales et la taille des gouttelettes variant d'une zone à l'autre, la taille des différentes zones et la différence de taille des gouttelettes entre deux zones étant suffisantes pour permettre un fonctionnement en monomode du laser 10 dans une large plage de courant de polarisation.

Selon un autre mode de réalisation du laser 10 dit à profil continue illustré en regard de la **figure 2C**, la zone 25 contient des gouttelettes de cristal dont la taille varie de manière continue entre différentes régions de la zone 25, cette variation se faisant dans un plan transverse du laser 10. Ainsi, par exemple, la taille des gouttelettes peut varier selon un profil gaussien d'écart type $\sigma$ égal à 2 µm en fonction de la distance $r$ des gouttelettes à l'axe du laser 10 entre une valeur minimale égale à approximativement 100 µm au centre et une valeur maximale voisine de 500 µm sur la partie extérieure accolée à la couche 26. Dans ce cas, dans la zone 25, le coefficient de perte $\alpha_{npdlc}$ en fonction de la distance $r$ suit la relation suivante :

$$\alpha_{npdlc}(r) = 13 + (50-13)(1-e^{-r^2/w^2}) = 13 + 37(1-e^{-r^2/w^2}).$$

Selon une variante de l'invention, la taille des gouttelettes varie continuement suivant une loi quelconque permettant de favoriser un mode transverse du laser au détriment des autres modes, par exemple selon un profil Lorentzien associé à un coefficient de perte $\alpha_{npdlc}$ en fonction de la distance $r$ qui suit la relation suivante (Lorentzienne inversée de largeur à mi hauteur égale à 4 µm) :

$$\alpha_{npdlc}(r) = 50 - \frac{148}{r^2 + 4} \quad \text{où la distance } r \text{ est exprimée en µm.}$$

D'une manière générale, la dimension des gouttelettes de cristal liquide peut être ajustée spatialement lors de l'insolation pour laquelle il est possible de mettre en oeuvre un filtre spatial d'amplitude complexe et, donc, de configurer l'insolation selon les différents profils de variation de taille de gouttelettes désirée.

Selon une variante de l'invention illustrée en regard de la figure 1, le point 14 est soumis à plusieurs potentiels $V1, V2, ... Vn$ et l'électrode 24 esr remplacée par un ensemble de $n$ électrodes reliée respectivement à un potentiel $V_1, V_2, ... V_n$ non nul. Selon un mode particulier de réalisation de cette variante, la zone 25 contient des bandes de nano-PDLC de forme cylindrique ou parallélipédique, parallèle à l'axe z et comprise à l'intérieur de la zone 25 entre des électrodes sous tension $V_1, V_2,...$ et $V_n$, chacune des zones de nano-PDLC associées à ces électrodes étant soumise à un champ quasi constant et égal respectivement à $E_1, E_2,...$ et $E_n$. Ainsi, chacune de ces zones de nano-PDLC possède son propre indice respectivement $n_1$, $n_2$ et $n_n$ permettant d'accorder indépendamment, avec un seul composant ayant une large plage de fonctionnement en monomode, des longueurs d'ondes $\lambda_1$, $\lambda_2$ ... et $\lambda_n$ et/ou son propre profil de taille de gouttelettes de nano-PDLC (la taille des gouttelettes ne faisant varier l'indice que faiblement comparativement aux tensions $V_1$, $V_2$,... et $V_n$). Ainsi, il est possible d'émettre vers chacune des fibres associées au composant un faisceau avec une seule longueur d'onde précise (fonctionnement en monomode), accordée en fonction du potentiel $V_i$ appliquée à l'électrode correspondante indépendamment des autres faisceaux et/ou de fabriquer des « wafers » (ou « galette » en français) de composants pouvant être séparés et utilisés indépendamment.

### 3. Réalisation des différentes parties du composant.

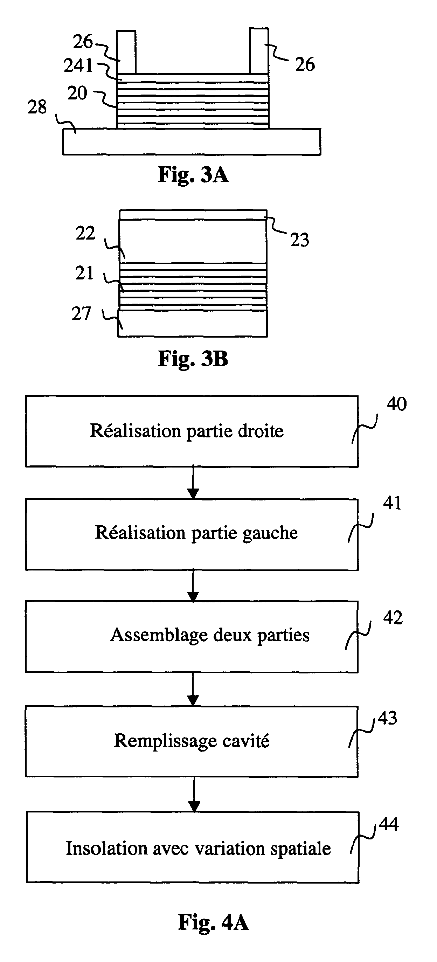

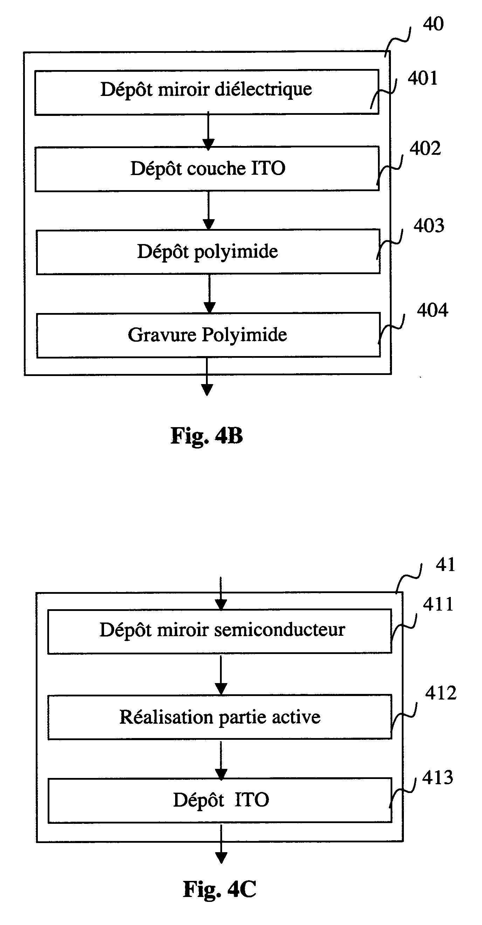

La **figure 3A** décrit plus précisément l'extrémité comprenant la cavité 25 remplie de nano-PDLC du laser 10 par laquelle se fait l'émission du faisceau lumineux et la **figure 4B** son mode de réalisation.
La réalisation 40 de cette extrémité du composant (partie gauche sur la figure 2A) se fait en plusieurs étapes.
Au cours d'une première étape 401, le miroir 20 de Bragg diélectrique est déposé sur une plaque de verre 28 de qualité optique par dépôt sous vide.
Ensuite, au cours d'une étape 402, une couche fine d'ITO constituant la première électrode permettant la polarisation de la couche de nano-PDLC est déposée.
Selon une variante décrite précédemment qui permet d'accorder indépendamment plusieurs faisceaux dans un même laser la couche d'ITO est gravée pour permettre la réalisation d'électrodes circulaires (en remplacement de l'électrode 24) que l'on peut polariser indépendamment. On peut ainsi réaliser une matrice de composants indépendants ou un composant émettant dans plusieurs longueurs d'ondes.
Ensuite, au cours d'une étape 403, une couche sacrificielle 26 de polyimide est déposée à la tournette avec une épaisseur contrôlée à moins de 2% près.
Puis, au cours d'une étape 404, cette couche est attaquée par gravure sélective de manière à laisser des plots permettant ensuite de plaquer cette partie à la seconde partie du laser 10 en faisant apparaître un espace d'épaisseur contrôlé à moins de 2% près dans la cavité qui pourra être remplie de nano-PDLC.
La **figure 3B** décrit plus précisément l'extrémité opposée du laser 10 et la **figure 4C** son mode de réalisation.
La réalisation 41 de l'extrémité comprenant la zone 22 comprenant le Bragg semiconducteur 21 (partie droite sur la figure 2A) se fait également en plusieurs étapes.
Au cours d'une première étape 411, le Bragg semiconducteur est fabriqué par dépôt sous vide et successif des paires (épitaxie) sur un substrat d'InP 27.
Ensuite, au cours d'une étape 412, on fait croître grâce par épitaxie la partie active 22 du composant.
Puis, au cours d'une étape 413, une couche fine d'ITO constituant l'électrode 23 reliée à la masse 15 est déposée.
La **figure 4A** décrit plus globalement la réalisation du laser 10.
Au cours des deux premières étapes 40 et 41, on réalise les deux parties du composant comme illustré en regard des figures 4B et 4C.
Puis, au cours d'une étape 42, on plaque les deux parties du composant ainsi réalisées.
Ensuite, au cours d'une étape 43, on remplit la cavité formée par assemblage des deux parties, de nano-PDLC sous forme de mélange de cristal liquide et de polymère liquide.
Puis, au cours d'une étape 44 on effectue une insolation du nano-PDLC avec variation spatiale pour faire polymériser le polymère et ainsi former les gouttelettes de crystal liquide dans la matrice solidifiée de polymères qui colle les deux parties du laser.
En effet, le procédé de fabrication de la zone de phase variable nécessite l'insolation UV (ultra-violet) du mélange cristal liquide/polymère placé dans la cavité 25 à travers le miroir de Bragg diélectrique 20. La puissance UV notée $P_{UV}$ utilisée contrôle la taille des gouttelettes de cristal liquide dispersées dans la matrice de polymère et donc la valeur du coefficient de perte associé à la diffusion dans la zone de phase. Selon l'invention, on insole sélectivement cette couche à l'aide d'un masque (ou filtre UV) adapté de manière à obtenir par exemple :

- une faible valeur du coefficient de perte $\alpha_{npdlc}$ égal à 13cm$^{-1}$ pour une puissance d'insolation $P_{UV}$ valant 350mW/cm$^2$, (un coefficient de perte $\alpha$ étant, par définition, le coefficient de perte de puissance optique dans un matériau. Si $P_0$ et $P_1$ sont les puissances respectivement incidente et transmise par le matériau et $l$ la longueur du matériau, $P_0$ et $P_1$ suivent la relation $P_1 = P_0 e^{-\alpha l}$) sur un cylindre de quelques microns de diamètre et permettant d'obtenir la zone 252 illustrée en regard de la figure 2B ; et
- une valeur plus forte du coefficient de perte $\alpha_{npdlc}$ égal à 50cm$^{-1}$ pour une puissance d'insolation $P_{UV}$ valant 300mW/cm$^2$ autour de ce cylindre et permettant d'obtenir la zone 251 illustrée en regard de la figure 2B .

On obtient ainsi un laser avec un profil de pertes binaire comprenant deux zones 251 et 252 à symétrie axiale

**EP 1 482 611 A1**

(cylindres imbriqués possédant le même axe) des coefficients de perte optique différents.

Ceci permet d'avoir une valeur faible du coefficient de perte modale moyen de la cavité pour le mode LP01 et une valeur forte pour celui du mode LP11 sans grande modification du déphasage qui détermine la plage d'accordabilité.

En utilisant un tel profil transverse de pertes qui favorise le mode fondamental, le laser reste monomode transverse sur une grande plage de courant de polarisation. La variation transverse de la taille des gouttelettes ne provoque pas de variation transverse de l'indice à champ nul de même, la valeur maximale de la variation de l'indice est la même dans les zones 251 et 252.

La saturation de la variation de l'indice sera atteinte pour des champs plus forts au centre ce qui provoque une modification des conditions de guidage des modes. Cependant, cet effet est négligeable pour la faible différence de puissance d'insolation indiquée et qui est nécessaire à la sélection modale. En d'autres termes, on néglige les différences d'indice dans les zones 251 et 252, quel que soit le champ appliqué.

### 4. Optimisation du profil d'insolation.

Les **figures 6 à 9** illustrent différents comportement du laser 10 selon l'invention en fonction notamment de l'intensité de polarisation, du type de profil d'insolation (binaire ou continu de type gaussien entraînant un profil de pertes correspondant du composant laser) et du rayon du profil d'insolation.

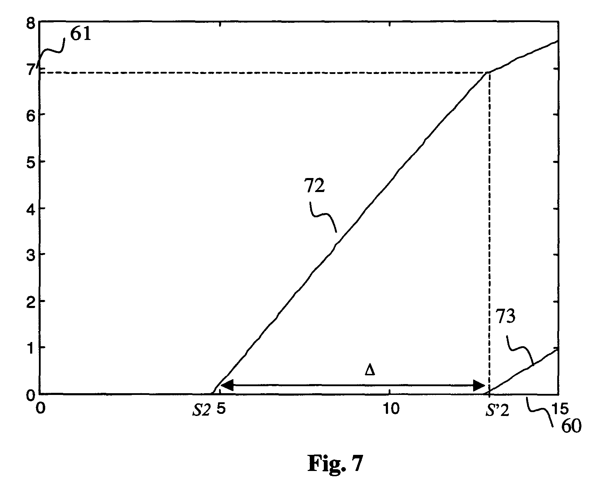

Plus précisément, les figures 6 et 7 illustrent la puissance optique 61 du laser 10 émise dans les modes LP01 et LP11 en fonction du courant de polarisation 60 pour respectivement :

- un profil d'insolation binaire permettant d'obtenir une cavité dont une coupe est illustrée en regard de la figure 2B ; et
- un profil d'insolation gaussien permettant d'obtenir une cavité dont une coupe est illustrée en regard de la figure 2C.

Selon la figure 6 (respectivement 7), une courbe 62 (respectivement 72) illustre plus précisément l'évolution de la puissance émise dans le mode transverse fondamental dit LP01 alors que la courbe 63 (respectivement 73) correspond à la puissance émise dans un deuxième mode associé au premier mode transverse dit LP11. Le seuil $S1$ (respectivement $S2)$ du mode LP01 se situe vers 4,2 mA (respectivement 4,7 mA) alors que le seuil $S'1$ (respectivement $S'2$) est voisin de 13,7 mA. Ainsi, le VCSEL est donc monomode pour une intensité de polarisation située entre 4,4 mA (respectivement 4,7 mA) et 13,7 mA (respectivement 12,8 µm) et multimode lorsqu'elle dépasse 13,7 mA (respectivement 12,8 µm). On constate que l'écart $\Delta$ entre les seuils $S1$ et $S'1$ (respectivement $S2$ et $S'2$) est de l'ordre de 9,5 mA (respectivement 8,1 mA), ce qui est considérablement plus élevé que l'écart illustré en figure 5 correspondant à une même structure sans profil transverse variable (c'est-à-dire avec profil de perte uniforme égal à 13 cm$^{-1}$ dans un plan transverse de nano-PDLC). Aussi, selon l'invention, il est relativement facile d'obtenir un fonctionnement en monomode avec un tel VCSEL. En outre, en fonctionnement monomode, la puissance optique peut atteindre environ 8,2 avec une insolation binaire et 6,8 avec une insolation gaussienne que l'on peut comparer à 2 avec un profil de pertes uniforme tel qu'illustré en regard de la figure 5 (les échelles de puissances étant les mêmes dans les différentes figures). Ainsi, on augmente également la puissance optique disponible en émission monomode.

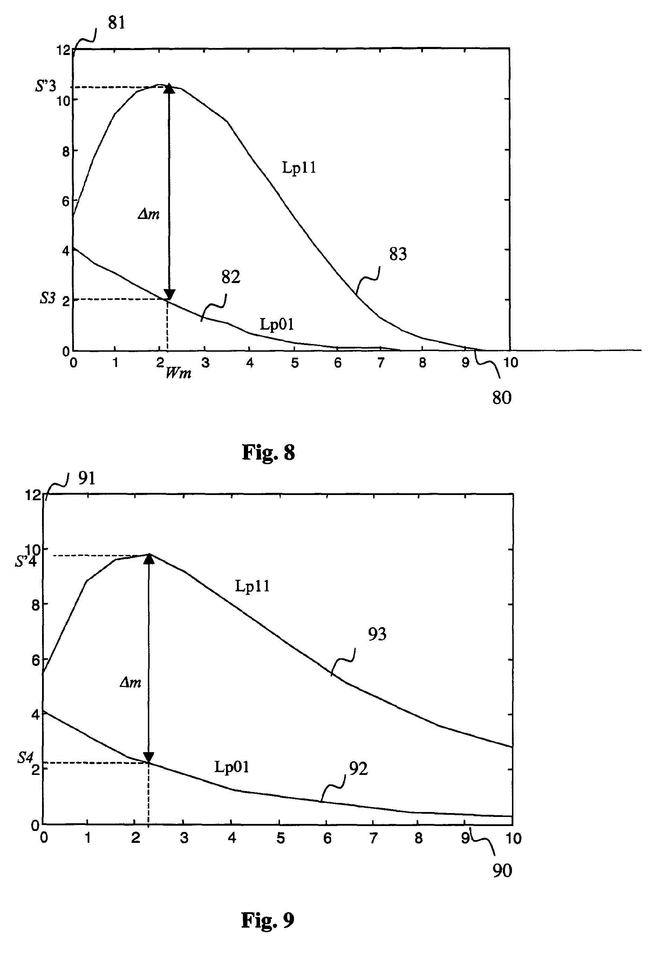

Les **figures 8 et 9** illustrent l'évolution des courants de seuils relatifs (différence entre le courant de seuil du mode pour un profil de rayon w et le courant au seuil du même mode sans profil transverse) pour le mode transverse fondamental LP01 et le premier mode transverse LP11 en fonction du rayon w associé respectivement à une insolation binaire (courbes respectivement 82 et 83) et à une insolation gaussienne (courbes respectivement 92 et 93) correspondant à un laser similaire au laser illustré en regard des figures respectivement 2B et 2C.

Pour les deux profils (binaire ou gaussien), le seuil relatif du mode LP01 tend vers 0 lorsque le rayon augmente (c'est-à-dire lorsque l'on se rapproche du cas sans profil). En revanche, le seuil relatif correspondant aux modes LP11 augmente pour les faibles rayons, passe par un optimum et décroît ensuite vers 0. L'écart $\Delta$ entre les seuils correspondant à LP01 et à LP11 est quasi maximal lorsque le seuil relatif correspondant au premier mode transverse est maximal et est obtenu pour une valeur de $w$ proche de 2 µm dans les deux types de profil (binaire ou gaussien).

Pour l'optimum, une plus grande plage de courant de polarisation en fonctionnement monomode peut être atteinte dans le cas du profil binaire (de l'ordre de 9,5 mA) que dans le cas du profil gaussien (plage maximale de l'ordre de 8,1 mA). Pour le profil gaussien, les seuils tendent vers leur valeur sans profil (cas où les pertes dans un plan transverse sont constantes) plus lentement en fonction du rayon du fait de la décroissance infinie de la courbe gaussienne.

### 5. Dynamique du laser avec un champ d'accordabilité nul.

La fréquence de résonance du laser 10 est donnée par la relation suivante :

$$f_r = \frac{1}{2\pi} \sqrt{\eta_i \frac{\Gamma V_g}{q\,V} \frac{\partial g}{\partial N} (I - I_s)}$$

où :

- $\eta_i$ est le rendement quantique interne du VCSEL 10 ;
- $\Gamma$ le facteur de confinement ;
- $V_g$ la vitesse de groupe dans le matériau de la cavité ;
- q la charge de l'électron ;
- V le volume de la cavité 25 ;
- $\frac{\partial g}{\partial N}$ le gain différentiel ;
- I le courant de polarisation ; et
- $I_s$ le courant de polarisation au seuil.

La bande passante du VCSEL est donnée par la relation :

$$f_{3dB} \approx 1{,}55\, f_r \text{ si les effets parasites ne sont pas trop importants}$$

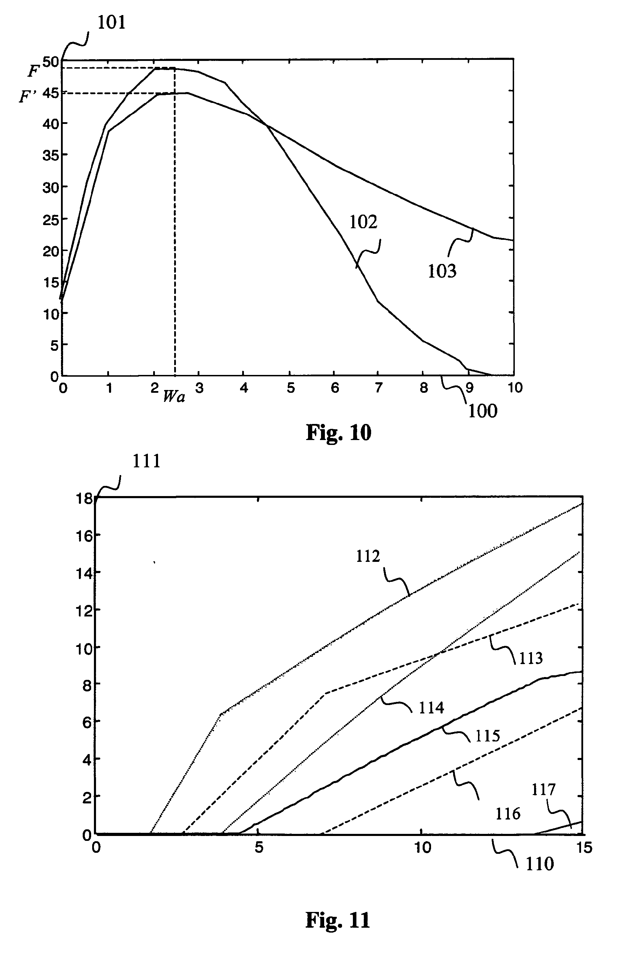

La **figure 10** donne l'évolution de la fréquence de résonance relative 101 (définie comme la différence entre la fréquence de résonance (qui est proche de la fréquence maximale à laquelle on peut moduler le laser 10 de manière directe) du laser avec profil de rayon w et la fréquence de résonnance du même laser sans profil de perte variable (*w* tendant vers l'infini, soit une fréquence de l'ordre de 18,5 GHz) en fonction 100 du rayon w du profil pour le cas binaire (courbe 102) ou gaussien (courbe 103). Cette fréquence est calculée pour le courant de polarisation correspondant au seuil du mode LP 11 (limite de fonctionnement monomode du laser 10).

La fréquence de résonance du VCSEL 10 est considérablement augmentée du fait de la présence d'un profil transverse de pertes. La fréquence de résonance est maximale pour un rayon *wa* voisin de 2,5 µm dans les deux cas binaire (fréquence maximale *F* égale à 67,6 GHz) et gaussien (fréquence maximale *F'* égale à 63,5 GHz) et décroît ensuite vers la valeur du cas sans profil transverse (18,5 GHz). Le profil binaire permet d'obtenir les meilleures performances en permettant une fréquence maximale de résonance plus élevée qu'avec un profil gaussien et donc une meilleure bande passante du VCSEL 10.

## 6. Effet de l'application d'un champ pour accorder le laser.

La **figure 11** illustre la variation de la puissance optique émise 111 en fonction de l'intensité de polarisation 110, cette puissance étant obtenue par simulation pour différentes valeurs de tension V1 appliquée à la zone 25 de phase variable et permettant d'accorder la longueur d'onde de résonance du laser 10 :

- les courbes correspondent 112 et 114 correspondent à une valeur de V1 égale à 100 V pour les modes respectivement fondamental transverse LP01 et premier ordre transverse LP11 ;
- les courbes correspondent 113 et 116 correspondent à une valeur de V1 égale à 50 V pour les modes respectivement LP01 et LP11 ; et
- les courbes correspondent 115 et 117 correspondent à une valeur nulle de V1 pour les modes respectivement LP01 et LP11.

Les trois tensions simulées égales respectivement à 0V, 50V et 100V permettent de couvrir toute la bande d'accordabilité du laser 10.

La variation avec le champ appliqué associé à la tension du coefficient de pertes du nano-PDLC sur l'ensemble du profil transverse a été prise en compte.

Le profil simulé est un profil binaire avec un rayon *w* égal à 2µm.

Lorsque la tension $V_1$ augmente, la diminution des pertes dans la couche de nano-PDLC entraîne une diminution des seuils des modes LP01 et LP11. En pratique, le coefficient de perte $\alpha$ diminue faiblement lorsque la tension V1 passe de 0 à 10 V, décroit quasiment linéairement et plus fortement lorsque la tension V1 varie de 10 à 80 V et reste pratiquement constant lorsque V1 dépasse une valeur proche de 80 V (il y a alors saturation).

Par ailleurs, la fenêtre de courant de polarisation en fonctionnement monomode (ou l'écart $\Delta$ entre les seuils de polarisation) diminue si la tension $V_1$ augmente, puisque l'écart entre les pertes modales associées respectivement à des parties proche et éloignée de l'axe du laser diminue.

En revanche, la puissance d'émission laser augmente lorsque la tension V1 augmente puisque les pertes optiques dans la couche de nano-PDLC diminuent.

Un compromis entre puissance d'émission et largeur de la plage de fonctionnement en monomode permettant de favoriser l'un ou l'autre de ces aspects peut être trouvé avec une grande souplesse en choisissant de manière adéquate la tension V1 entre 0 et environ 100 V.

Si une accordabilité du laser est recherchée tout en ayant une large plage de fonctionnement monomode et une puissance d'émission relativement élevée, on définit préférentiellement le laser en se plaçant à une tension V1 proche de 50 V et on fait varier V1 autour de cette valeur pour accorder le laser ainsi obtenu.

Bien entendu, l'invention n'est pas limitée aux exemples de réalisation mentionnés ci-dessus.

Selon l'invention, l'introduction d'un profil transverse de pertes dans la cavité d'un VCSEL permet d'augmenter considérablement la plage de courant de polarisation en fonctionnement monomode et sa bande passante.

En particulier, l'homme du métier pourra apporter toute variante dans la nature des profils des éléments optiques qui n'est pas limitée au profil binaire ou gaussien mais qui peut comprendre :

- plusieurs zones correspondant à des tailles de gouttelettes différentes dans un plan perpendiculaire à la direction de propagation optique du laser ; ou
- une ou plusieurs zones dans lesquelles les tailles gouttelettes varie de manière sensiblement continue.

Le profil binaire avec un rayon de 2μm fournit de meilleures performances côté laser qu'un profil gaussien. Un profil intermédiaire entre binaire et gaussien peut être utilisé afin d'améliorer l'homogénéité du profil binaire dans la dynamique de formation des gouttelettes.

L'homme du métier pourra également apporter toute variante dans l'évolution de la variation de la taille des gouttelettes dans le cas d'une variation continue ou dans les différences entre les tailles de gouttelettes lorsqu'il y a plusieurs zones correspondant chacune à une taille de gouttelettes.

Le procédé de fabrication ne se limite pas au cas où l'insolation est effectuée avec une lampe émettant une puissance spatiale constante, la lumière étant par la suite filtrée par un filtre adapté filtrant plus ou moins fortement la lumière en fonction du diamètre de gouttelette désiré dans une zone correspondante mais s'étend à toute insolation permettant d'obtenir des gouttelettes de taille variable spatialement. Il est notamment possible de fabriquer un laser selon l'invention en balayant la surface d'un mélange crytal-polymère avec une source laser ultra-violette très fine et réglable en puissance.

Selon l'invention, l'intérieur de la cavité peut également contenir un élément optique non actif, par exemple de type semi-conducteur, (en sus ou à la place d'un élément optique actif tel que le nano-PDLC) dont on décale le spectre d'absorption localement en appliquant un champ électrique, selon l'effet Franz Keldysch. Ainsi, dans la cavité contenant l'élément optique non actif, on définit des profils transverses à coefficient de perte variable par application d'un champ électrique variable dans un plan transverse.

On peut notamment définir un profil binaire dans lequel on identifie deux zônes (de manière similaire au mode de réalisation précédemment décrit en regard de la figure 2B) en fonction d'un champ électrique appliqué sur chacune de ses zônes :

- une première zône cylindrique centrale de rayon égal à 2 μm placée sur l'axe du laser ; et
- une deuxième zône entourant la première zône de rayon interne valant 2 μm et de rayon externe proche de 50 μm.

Dans ce cas, on applique un champ électrique E2 (respectivement E3) parallèles à l'axe du laser (généré par une différence de potentiel entre une électrode reliée à la masse et une électrode à laquelle on applique une tension V2 (respectivement V3), les électrodes étant placées perpendiculairement à l'axe du laser à chaque extrémité de la première (respectivement deuxième) zône. Si la tension V2 est nulle ou proche de 0 V et si la tension V3 est suffisante pour créer un coefficient de perte sur la deuxième zône (V3 étant par exemple supérieure à 100 V), le premier mode transverse sera affecté par les pertes sur la deuxième zône, le mode fondamental étant, en revanche favorisé, ce qui permet une émission en monomode selon le mode fondamental sur une large plage de seuil de polarisation. Si, au contraire, la tension V3 est nulle ou proche de 0 V et si la tension V2 est suffisante pour créer un coefficient de perte sur la première zône (V2 étant par exemple supérieure à 100 V), le premier mode transverse sera favorisé au détriment du mode fondamental transverse, ce qui permet une émission en monomode selon le premier mode transverse sur une large plage de seuil de polarisation.

Bien entendu, ce fonctionnement permet également une accordabilité du laser : on peut, par exemple, mettre en oeuvre une tension V2 (respectivement V3) nulle ou proche de 0 V et une tension V3 (respectivement V2) variant autour de 50 V pour accorder la longueur d'onde du laser en mode monomode favorisant le mode fondamental (respectivement premier mode) transverse.

L'invention trouve des applications dans le domaine des télécommunications (notamment dans la transmission de données à faible ou fort débit, dans la transmission de données sur fibres multimodes...) mais également dans de nombreux autres domaines mettant en oeuvre des faisceaux lasers (notamment en médecine).

L'invention n'est pas limitée au cas où le laser favorise le mode transverse fondamental mais concerne également le cas où le premier mode transverse ou un autre mode transverse est favorisé au détriment du mode fondamental. Dans ce cas, les gouttelettes de cristal sont plus grosses au centre qu'à l'extérieur et le seuil de polarisation correspondant au premier mode transverse devient inférieur au seuil de polarisation associé au mode transverse fondamental. On peut ainsi obtenir un faiceau en forme de beignet (disque avec centre creux) qui peut convenir à certaines applications (par exemple en médecine).

Le laser selon l'invention peut notamment être utilisé en tant que source laser, amplificateur, commutateur et/ou porte optique.

Par ailleurs, l'application d'une tension à la zone de phase pour faire varier la longueur d'onde de résonance entraîne une diminution de la plage en fonctionnement monomode.

**Revendications**

1. Laser (10) à cavité verticale et à émission surfacique (VCSEL) comprenant à l'intérieur de ladite cavité (25) au moins un élément optique, **caractérisé en ce que** ledit au moins un élément optique possède à la fois une phase variable et un profil de perte optique variable dans un plan perpendiculaire à un axe de propagation d'au moins un faisceau lumineux (17) traversant ladite cavité de sorte à favoriser un mode transverse dudit laser.

2. Laser selon la revendication 1, **caractérisé en ce que** ledit mode transverse est le mode transverse fondamental.

3. Laser selon la revendication 1, **caractérisé en ce que** ledit mode transverse est le premier mode transverse.

4. Laser selon l'une quelconque des revendications 1 à 3, **caractérisé en ce qu'**on distingue dans ledit plan au moins deux zones (251, 252), ledit profil de perte étant sensiblement constant dans au moins une desdites zones et différent dans deux zones distinctes.

5. Laser selon la revendication 4, **caractérisé en ce que** le rayon d'une zone centrale parmi lesdites zones est compris entre 1 et 5 $\mu$m.

6. Laser selon l'une quelconque des revendications 1 à 5, **caractérisé en ce que** ledit profil de perte varie de manière sensiblement continue dans au moins une partie dudit plan.

7. Laser selon la revendication 6, **caractérisé en ce que** ledit profil de perte varie de manière sensiblement gaussienne dans au moins une partie dudit plan.

8. Laser selon la revendication 7, **caractérisé en ce que** l'écart type de la variation gaussienne dudit profil de perte dans une zône centrale est compris entre 1 et 5 $\mu$m.

9. Laser selon l'une quelconque des revendications 1 à 8, **caractérisé en ce que** la variation dudit profil de perte dans ledit plan est à symétrie axiale.

10. Laser selon l'une quelconque des revendications 1 à 9, **caractérisé en ce qu'**au moins un desdits éléments optiques comprend des gouttelettes (291, 292, 293) d'une première composition dispersées dans un produit d'une seconde composition, le diamètre desdites gouttelettes étant variable dans ledit plan.

11. Laser selon la revendication 10, **caractérisé en ce qu'**au moins un desdits éléments optiques comprend un matériau de type nano-PDLC.

12. Laser selon l'une quelconque des revendications 1 à 11, **caractérisé en ce qu'**il comprend des moyens d'application (14, 15, 23, 27) d'un champ électrique permettant d'accorder une longueur d'onde associée audit laser.

13. Laser selon l'une quelconque des revendications 1 à 12, **caractérisé en ce qu'**il forme un laser de type source laser.

**14.** Laser selon l'une quelconque des revendications 1 à 13, **caractérisé en ce qu'**il comprend successivement :

- une première extrémité (28) adaptée à permettre l'émission d'un faisceau laser ;
- un premier miroir (20);
- ladite cavité comprenant ledit au moins un élément optique ;
- une première électrode (23) reliée à un premier potentiel électrique ;
- une zône (22) active à multipuits quantique ;
- un second miroir (21) ; et
- une seconde électrode (27) reliée à un second potentiel électrique.

**15.** Laser selon la revendication 14, **caractérisé en ce que** ledit second miroir est du type Bragg semi-conducteur.

**16.** Laser selon l'une quelconque des revendications 14 et 15, **caractérisé en ce qu'**il comprend une troisième électrode (24) accolée audit premier miroir et reliée à au moins un troisième potentiel électrique.

**17.** Système de télécommunications à haut débit, **caractérisé en ce qu'**il comprend au moins un laser selon l'une quelconque des revendications 1 à 16 coopérant avec au moins une fibre optique permettant l'émission d'au moins un faisceau lumineux émis par ledit laser.

**18.** Procédé de fabrication d'un laser à cavité verticale et à émission surfacique (VCSEL), **caractérisé en ce qu'**il comprend :

- une étape de choix d'au moins un élément optique possédant une phase variable ;
- une étape de réalisation d'une partie dudit laser comprenant ledit élément optique ; et
- une étape d'insolation (44) dudit élément optique selon un profil d'insolation variable dans un plan perpendiculaire à un axe de propagation d'au moins un faisceau lumineux dans ledit laser.

**19.** Procédé selon la revendication 18, **caractérisé en ce qu'**on distingue dans ledit plan au moins deux zones, ledit profil d'insolation étant sensiblement constant dans au moins une desdites zones et différent dans deux desdites zones distinctes.

**20.** Procédé selon l'une quelconque des revendications 18 et 19, **caractérisé en ce que** ledit profil d'insolation varie de manière sensiblement continue dans au moins une partie dudit plan.

**21.** Procédé selon la revendication 20, **caractérisé en ce que** ledit profil d'insolation varie de manière sensiblement gaussienne dans au moins une partie dudit plan.

**22.** Procédé selon l'une quelconque des revendications 18 à 21, **caractérisé en ce que** la variation dudit profil d'insolation dans ledit plan est à symétrie axiale.

**23.** Procédé selon l'une quelconque des revendications 18 à 22, **caractérisé en ce que** ladite étape d'insolation met en oeuvre :

- au moins une source lumineuse produisant un faisceau d'insolation ; et
- au moins un filtre adapté à faire varier ledit faisceau d'insolation suivant ledit profil d'insolation.

Emission(λ)

17

10

Laser

14 $V_p$   15   16 $V_1$

**Fig. 1**

28

10

20   25   26   23   22   21   27
A

Bragg
DiEl.   PDLC   Multi-puits
quantique   Bragg
SemiC.   InP   z

17

mλ/2   pλ/2

14   24   A   26
$V_1$   15   16
$V_p$

**Fig. 2A**

**Fig. 2B**

**Fig. 2C**

**Fig. 3A**

**Fig. 3B**

Réalisation partie droite — 40

Réalisation partie gauche — 41

Assemblage deux parties — 42

Remplissage cavité — 43

Insolation avec variation spatiale — 44

**Fig. 4A**

40

401
Dépôt miroir diélectrique

402
Dépôt couche ITO

403
Dépôt polyimide

404
Gravure Polyimide

**Fig. 4B**

41

411
Dépôt miroir semiconducteur

412
Réalisation partie active

413
Dépôt ITO

**Fig. 4C**

ETAT DE L'ART

**Fig. 5**

**Fig. 6**

Fig. 7

**Fig. 8**

**Fig. 9**

**Fig. 10**

**Fig. 11**

**Office européen des brevets**

# RAPPORT DE RECHERCHE EUROPEENNE

Numéro de la demande

EP 04 36 4034

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| Y | US 5 301 201 A (VAKHSHOORI DARYOOSH ET AL) 5 avril 1994 (1994-04-05) <br> * abrégé; figure 1 * <br> * colonne 2 - colonne 3 * <br> ----- | 1,2,4,5, 9-17 | H01S5/183 <br> H01S3/098 |
| Y | MORGAN R A ET AL: "HYBRID DIELECTRIC/ALGAAS MIRROR SPATIALLY FILTERED VERTICAL CAVITY TOP-SURFACE EMITTING LASER" APPLIED PHYSICS LETTERS, AMERICAN INSTITUTE OF PHYSICS. NEW YORK, US, vol. 66, no. 10, 6 mars 1995 (1995-03-06), pages 1157-1159, XP000503633 ISSN: 0003-6951 <br> * abrégé; figure 1 * <br> * page 1157, colonne de gauche, ligne 28 - ligne 31 * <br> * page 1158 * <br> ----- | 1,2,4,5, 9-17 | |
| X | VERBRUGGE V ET AL: "C-band wavelength-tunable vertical-cavity laser using a nano polymer dispersed liquid crystal material" OPTICS COMMUNICATIONS, NORTH-HOLLAND PUBLISHING CO. AMSTERDAM, NL, vol. 215, no. 4-6, 15 janvier 2003 (2003-01-15), pages 353-359, XP004402087 ISSN: 0030-4018 <br> * abrégé; figure 1 * <br> * page 353 - page 355 * <br> ----- | 1,2,6-13 | DOMAINES TECHNIQUES RECHERCHES (Int.Cl.7) <br><br> H01S |
| X | DE 101 05 722 A (OSRAM OPTO SEMICONDUCTORS GMBH) 5 septembre 2002 (2002-09-05) <br> * le document en entier * <br> ----- | 1,2,4,6, 9,17 | |

-/--

Le présent rapport a été établi pour toutes les revendications

| Lieu de la recherche | Date d'achèvement de la recherche | Examinateur |
|---|---|---|
| Munich | 2 août 2004 | Meacher, D |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons

........................................................................
& : membre de la même famille, document correspondant

EPO FORM 1503 03.82 (P04C02)

**Office européen des brevets**

**RAPPORT DE RECHERCHE EUROPEENNE**

Numéro de la demande

EP 04 36 4034

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | PEREIRA S F ET AL: "Birefringence in TEM01 optically-pumped VCSELs" OPTICS COMMUNICATIONS, NORTH-HOLLAND PUBLISHING CO. AMSTERDAM, NL, vol. 153, no. 4-6, 1 août 1998 (1998-08-01), pages 282-284, XP004146365 ISSN: 0030-4018 * abrégé * * page 282 * | 1,3,6 | |
| D,A | FR 2 825 524 A (GET ENST BRETAGNE) 6 décembre 2002 (2002-12-06) * le document en entier * | 1-23 | |
| A | MATSUMOTO SHIRO ET AL: "Nano-sized fine droplets of liquid crystals for optical application" MATER RES SOC SYMP PROC; MATERIALS RESEARCH SOCIETY SYMPOSIUM PROCEEDINGS; NANOPHASE AND NANOCOMPOSITE MATERIALS II 1997 MATERIALS RESEARCH SOCIETY, PITTSBURGH, PA, USA, vol. 457, 2 décembre 1996 (1996-12-02), pages 89-92, XP001182292 * page 89 - page 90 * | 10-12, 18-23 | DOMAINES TECHNIQUES RECHERCHES (Int.Cl.7) |
| A | DANILOV V V ET AL: "TRANSVERSELY EXCITED ATMOSPHERIC CO2 LASER WITH AN INTRACAVITY LIQUID CRYSTAL STOP" SOVIET JOURNAL OF QUANTUM ELECTRONICS, AMERICAN INSTITUTE OF PHYSICS. WOODBURY, NY, US, vol. 21, no. 10, 1 octobre 1991 (1991-10-01), pages 1099-1101, XP000256490 * abrégé; figure 1 * * page 1099 - page 1100 * | 1-16 | |

-/--

Le présent rapport a été établi pour toutes les revendications

| Lieu de la recherche | Date d'achèvement de la recherche | Examinateur |
|---|---|---|
| Munich | 2 août 2004 | Meacher, D |

**Office européen des brevets**

## RAPPORT DE RECHERCHE EUROPEENNE

Numéro de la demande

EP 04 36 4034

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| D,A | SARGENT L J ET AL TINGYE LI: "Gaussian etched single transverse mode vertical-cavity surface-emitting laser" CONFERENCE ON LASERS AND ELECTRO-OPTICS. (CLEO 2000). TECHNICAL DIGEST. POSTCONFERENCE EDITION. SAN FRANCISCO, CA, MAY 7 - 12, 2000, TRENDS IN OPTICS AND PHOTONICS. (TOPS), NEW YORK, NY : IEEE, US, vol. 39, 7 mai 2000 (2000-05-07), pages 166-167, XP002268070 ISBN: 0-7803-5990-9 * le document en entier * ----- | 1-23 | |
| A | FIREHAMMER J A ET AL: "FIRST IMAGES FROM AN IMAGE MODE LASER PROJECTION DISPLAY" PROCEEDINGS OF THE 18TH. INTERNATIONAL DISPLAY RESEARCH CONFERENCE. ASIA DISPLAY 98. SEOUL, SEPT. 28 - OCT. 1, 1998, INTERNATIONAL DISPLAY RESEARCH CONFERENCE. IDRC, SAN JOSE, CA : SID, US, vol. CONF. 18, 28 octobre 1998 (1998-10-28), pages 1171-1174, XP000921823 * figure 1 * ----- | 1-16 | DOMAINES TECHNIQUES RECHERCHES (Int.Cl.7) |

Le présent rapport a été établi pour toutes les revendications

| Lieu de la recherche | Date d'achèvement de la recherche | Examinateur |
|---|---|---|
| Munich | 2 août 2004 | Meacher, D |

**ANNEXE AU RAPPORT DE RECHERCHE EUROPEENNE**
**RELATIF A LA DEMANDE DE BREVET EUROPEEN NO.**                  EP 04 36 4034

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

02-08-2004

| Document brevet cité au rapport de recherche | | Date de publication | Membre(s) de la famille de brevet(s) | | Date de publication |
|---|---|---|---|---|---|
| US 5301201 | A | 05-04-1994 | DE | 69404701 D1 | 11-09-1997 |
|  |  |  | DE | 69404701 T2 | 26-02-1998 |
|  |  |  | EP | 0614256 A1 | 07-09-1994 |
|  |  |  | JP | 6318765 A | 15-11-1994 |
| DE 10105722 | A | 05-09-2002 | DE | 10105722 A1 | 05-09-2002 |
|  |  |  | WO | 02063733 A2 | 15-08-2002 |
|  |  |  | EP | 1374356 A2 | 02-01-2004 |
|  |  |  | JP | 2004518304 T | 17-06-2004 |
|  |  |  | US | 2004032892 A1 | 19-02-2004 |
| FR 2825524 | A | 06-12-2002 | FR | 2825524 A1 | 06-12-2002 |
|  |  |  | EP | 1393419 A1 | 03-03-2004 |
|  |  |  | WO | 02099941 A1 | 12-12-2002 |

EPO FORM P0460

Pour tout renseignement concernant cette annexe : voir Journal Officiel de l'Office européen des brevets, No.12/82